# EUROPEAN PATENT APPLICATION

(11) **EP 2 579 699 A1**
(43) Date of publication of application: **10.04.2013**
(21) Application number: 11786736.6
(22) Date of filing: 27.05.2011
(51) Int. Cl.: H05K 9/00, B32B 27/18, C08J 5/18, C08K 3/04, C08L 101/00

(54) **DIELECTRIC MATERIAL SHEET AND PROCESS FOR PRODUCTION THEREOF, AND ELECTROMAGNETIC WAVE ABSORBER**

(30) Priority: 27.05.2010 JP 2010122124
(71) Applicant: Nitto Denko Corporation, Osaka 567-8680 (JP)
(72) Inventor: WANO, Takashi, Ibaraki-shi Osaka 567-8680 (JP); TADA, Masataka, Ibaraki-shi Osaka 567-8680 (JP); FUKUDA, Yuuki, Ibaraki-shi Osaka 567-8680 (JP); HASHIMOTO, Osamu, Sagamihara-shi Kanagawa 252-5258 (JP); TAMARU, Ryoji, Sagamihara-shi Kanagawa 252-5258 (JP)
(74) Representative: Grünecker, Kinkeldey, Stockmair & Schwanhäusser
(86) International application number: PCT/JP2011/062166
(87) International publication number: WO 2011/149039

(57) **Abstract**

The dielectric sheet of the present invention is made of a sheet having a thickness of 5 - 30 µm, which is formed by drying a coated film of a coating liquid containing a resin and a natural graphite powder having an average particle diameter of 10 µm or less. Preferably, the sheet is formed from a coating liquid containing a resin, a natural graphite powder having an average particle diameter of 10 µm or less, and a solvent, wherein the content rate of the natural graphite powder to the resin exceeds 5% by volume and is not more than 20% by volume, and the total content of the resin and the natural graphite powder is 10 - 55 wt%.

## Description

### Technical Field

The present invention relates to a dielectric sheet which is light weight and thin, and has a superior radio wave absorbing capacity and a production method thereof, and a light weight and thin electromagnetic wave absorber (radio wave absorber) using such dielectric sheet.

### Background Art

In recent years, in the fields of semiconductor and electronics, higher frequencies of electromagnetic waves are more often used for computers and household electronic appliances, as well as so-called home information appliances such as cell phones and the like, and electromagnetic waves in gigahertz (GHz) band frequency with not less than one billion oscillations per second have been used frequently.

In addition, for increased convenience and safety of road traffic, Electronic Toll Collection system (ETC), on expressways, using electromagnetic waves of GHz band frequency and safe-driving support system using in-car radar device, which are comprehensively referred to as Intelligent Transport System (ITS), have been developed.

For example, patent document 1 proposes, as a radio wave absorber sheet to prevent malfunctions of devices that function in a radio wave frequency GHz band used for short range communications (e.g., ETC (Electronic Toll Collection system), operating frequency: 5.8 GHz), a radio wave absorber sheet obtained by applying a paste containing anisotropic graphite having an average particle diameter of 20 - 100 µm and a binder, same drying same to give a thin-wall coating absorber sheet (dielectric sheet), and alternately laminating the dielectric sheets in X direction and Y direction (direction after turning X direction by 90 degrees). It is described that, using such radio wave absorber sheet, a light weight and thin radio wave absorber sheet showing stable radio wave absorption property can be realized irrespective of the incident angle of the electromagnetic wave.

### Document List

### Patent Document

patent document 1: JP-A-2006-80352

### Summary of the Invention

### Problems to be Solved by the Invention

However, the present inventors produced the dielectric sheet (coating absorber sheet) described in patent document 1 according to the method described in the document and noted the following problems:
(a) dispersion of a graphite powder is not sufficient in a paste containing an anisotropic graphite and a binder, and a considerably large amount of a graphite powder needs to be added to afford stable radio wave absorption property, which prevents a radio wave absorber sheet produced by laminating the dielectric sheet from achieving a sufficiently light weight,
(b) since the dielectric sheet is weak, the strength of the radio wave absorber sheet is low, and
(c) since the thickness of one dielectric sheet (coating absorber sheet) is not less than 200 µm, a thinner radio wave absorber sheet has a limitation on the number of dielectric sheets (coating absorber sheets) to be laminated, and stable radio wave absorption property cannot always be obtained with ease.

The present invention has been made in view of the above-mentioned situation, and the problem to be solved is to provide a dielectric sheet which is thin and light weight and has superior electromagnetic wave (radio wave) absorbing capacity by using a comparatively small amount of graphite.
A further problem of the present invention is to provide an electromagnetic wave (radio wave) absorber which is thin and light weight, and shows stable electromagnetic wave (radio wave) absorption property, irrespective of the incident angle of electromagnetic wave (radio wave).

### Means of Solving the Problems

The present inventors have conducted intensive studies in an attempt to solve the aforementioned problems and found that, in a resin sheet obtained by thinly applying a coating liquid containing a resin and a natural graphite powder having an average particle diameter of 10 µm or less to form a coated film and drying same, a state of the natural graphite particles being oriented in a plane (that is, a state wherein the natural graphite particles (thin chips) are oriented such that the cleavage planes of the particles are parallel to a plane in the sheet, which plane is perpendicular to the thickness direction of the sheet) is formed in multiplicity along the thickness direction of the sheet, whereby a state of the cleavage planes of the graphite particles being orderly disposed in the planes perpendicular to the thickness direction of the sheet can be easily formed. Then, they have made further studies based on such findings and completed the present invention.

Accordingly, the present invention is characterized by the following.
(1) A dielectric sheet characterized in that it comprises a sheet having a thickness of 5 - 30 µm which is formed by drying a coated film of a coating liquid comprising a resin and a natural graphite powder having an average particle diameter of 10 µm or less.
(2) The dielectric sheet of (1), wherein the coating liquid comprises a resin, a natural graphite powder having an average particle diameter of 10 µm or less, and a solvent,
   the content rate of the natural graphite powder to the resin is more than 5% by volume and not more than 20% by volume, and
   the total content of the resin and the natural graphite powder is 10 - 55 wt%.
(3) A method of manufacturing a dielectric sheet comprising a natural graphite powder dispersed in a resin, comprising a step of adding 10 - 30 wt% of a natural graphite powder having an average particle diameter of 10 µm or less and 0.5 - 1.5 wt% of a dispersion stabilizer to a solvent to give a natural graphite powder dispersion liquid wherein the natural graphite powder is dispersed, mixing a resin with the natural graphite powder dispersion liquid to prepare a natural graphite powder-dispersed coating liquid wherein the content rate of the natural graphite powder to the resin is more than 5% by volume and not more than 20% by volume, and the total content of the resin and the natural graphite powder is 10 - 55 wt%,
   a step of applying the coating liquid to a support processed for exfoliation, and drying the liquid to form a coated film having a thickness of 5 - 30 µm, and
   a step of drying by heating the coated film to produce a sheet having a thickness of 5 - 30 µm, wherein the natural graphite powder having an average particle diameter of 10 µm or less is dispersed in the resin.
(4) An electromagnetic wave absorber, wherein a plurality of dielectric sheets of (1) or (2) are laminated.
(5) The electromagnetic wave absorber of (4), wherein the plurality of dielectric sheets are laminated such that the dielectric sheets laminated to abut each other are in the relationship of their machine directions forming a crossing angle of 90 degrees with each other.

### Effect of the Invention

According to the present invention, a thin and light weight dielectric sheet showing a superior radio wave absorbing capacity can be obtained without adding a large amount of graphite.
In addition, by laminating a plurality of such dielectric sheets, a thin and light weight dielectric sheet showing stable radio wave absorption property irrespective of the incident angle of electromagnetic wave can be realized.

### Brief Description of the Drawings

Fig. 1 shows an SEM photograph of a cross-section cut in the thickness direction of the dielectric sheet of one embodiment of the present invention.
Fig. 2 shows real parts and imaginary parts of complex dielectric constants of dielectric sheets according to the Examples and Comparative Examples of the present invention together with a non-reflective curve (5.8 GHz).
Fig. 3 shows variation of measurement values in the dielectric constant-measurement direction of the electromagnetic wave absorber of the present invention.

### Description of Embodiments

The present invention is explained the following by referring to a preferable embodiment thereof.
The dielectric sheet of the present invention is mainly characterized in that it comprises a sheet having a thickness of 5 - 30 µm, which is formed by drying a coated film of a coating liquid containing a resin and a natural graphite powder having an average particle diameter of 10 µm or less.

Graphite is a conductive material. A mixture (composite) of a graphite powder and a resin wherein the graphite powder is dispersed in the resin acts as a dielectric.
However, when the amount of a graphite powder filled in a resin becomes high, a conductive path due to agglomeration of graphite particles is significantly formed to markedly decrease the capacity to absorb electromagnetic waves. On the other hand, when the amount of a graphite powder filled is small, the dielectric constant (permittivity) of a mixture (composite) of a graphite powder and a resin becomes low to decrease an electromagnetic wave absorbing capacity.

The dielectric sheet of the present invention can be formed by forming a coated film having a thickness after drying of 5 - 30 µm from a natural graphite powder-dispersed coating liquid using a natural graphite powder having an average particle diameter of 10 µm or less, wherein the content rate of the natural graphite powder to the resin is more than 5% by volume and not more than 20% by volume, and drying the coated film.

That is, the present invention has found the following phenomena (A) and (B) and, based thereon, uses a comparatively small amount of a natural graphite powder (more than 5% by volume and not more than 20% by volume relative to the resin), whereby a thin and light-weight dielectric sheet having a superior radio wave absorbing capacity is realized.
(A) In a coated film obtained by applying a resin solution wherein a small-sized natural graphite powder having an average particle diameter of 10 µm or less is dispersed (natural graphite powder-dispersed coating liquid), the natural graphite powder is oriented in the coating direction of the coating liquid and easily oriented in-plane (that is, natural graphite particles (thin chips) are easily oriented such that their cleavage planes are parallel to the horizontal plane).
(B) In a coated film obtained by increasing the thickness of coating, the orientation of graphite is disturbed when the coated film is dried, and the dispersion state of the natural graphite powder oriented in-plane cannot be maintained. However, a coated film formed thin by coating in a thickness such that the thickness after drying is not more than 30 µm more remarkably shows orientation of the natural graphite powder in the coating direction, and the natural graphite powder is oriented in-plane, and the dispersion state wherein the natural graphite powder is oriented in-plane is maintained even when the coated film is dried.

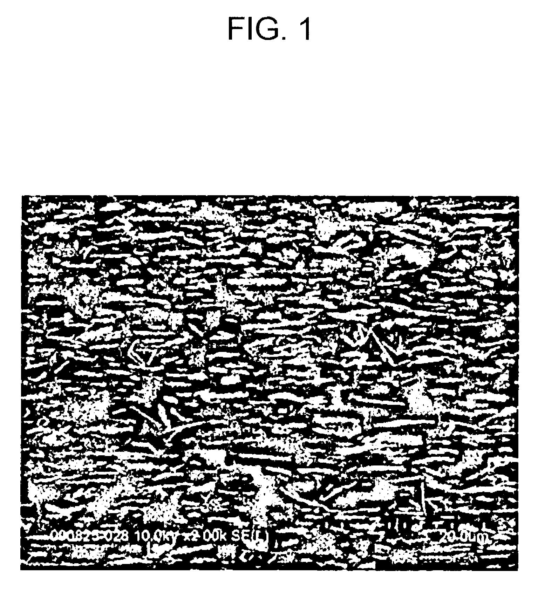

Fig. 1 is an electron micrograph (SEM photograph) of the cross section of the dielectric sheet prepared in the below-mentioned Example 2. As shown in Fig. 1, it is clear that natural graphite particles oriented in a plane (natural graphite particles (thin chips) are oriented such that their cleavage planes are parallel to the plane perpendicular to the thickness direction of the sheet) are formed in plurality in the thickness direction of the sheet.
Natural graphite becomes thin chip particles on grinding. The aforementioned cleavage plane is a plane that appears on the surface of each thin chip-like particle, as a main surface of the front and the back. As shown in the photograph of Fig. 1, the cleavage plane of each particle is disposed in a similar direction.
Therefore, due to such specific dispersion state of natural graphite particles, the dielectric sheet of the present invention shows dielectric anisotropy showing particularly high dielectric constant to the electromagnetic wave that enters from the direction perpendicular to the sheet surface (direction same as the thickness direction of the sheet). When the sheet surface faces the arrival direction of the electromagnetic wave, the sheet shows superior radio wave absorbing capacity.

The dielectric sheet of the present invention uses a natural graphite powder having an average particle diameter of 10 µm or less, preferably 8 µm or less. When a natural graphite powder having an average particle diameter exceeding 10 µm is used, a dispersion state wherein the natural graphite powder in the in-plane orientation is difficult to form in a coated film obtained by applying a natural graphite powder-dispersed coating liquid containing a resin and the natural graphite powder. On the other hand, when the average particle diameter of the natural graphite powder is too small, the dielectric constant of the obtained sheet tends to decrease. Hence, the average particle diameter of the natural graphite powder is preferably not less than 3 µm, more preferably not less than 5 µm.

Artificial graphite is not suitable for the dielectric sheet of the present invention. This is because it has good electrical conductivity and forms a conductive path with ease, and moreover, since artificial graphite does not have a developed layer structure, dispersion thereof in the state of in-plane orientation is difficult.

The "average particle diameter of the natural graphite powder" in the present invention means a median diameter (d50) in the particle size distribution (cumulative distribution) on a volumetric basis as measured by the laser diffraction scattering method. In the Examples of the present invention, the average particle diameter was measured using Microtrack MT3000 II manufactured by NIKKISO CO., LTD.

Natural graphite includes α-graphite and β-graphite depending on the difference in the lamination state of graphite layer structures. While both of them can be used as a natural graphite powder in the present invention, α-graphite powder, which is a general natural graphite powder, is generally used.

A natural graphite powder having an average particle diameter of 10 µm or less can be obtained by milling natural graphite in a suitable milling apparatus such as collision type crusher (jet mill, ball mill etc.) and the like, and classifying the particles as necessary.

A natural graphite powder having an average particle size of 10 µm or less is preferably free of coarse particles having a particle diameter exceeding 30 µm, and preferably free of ultra-microparticles having a particle diameter of less than 1 µm. When such coarse particles and ultra-microparticles are not contained, a dispersion state of the natural graphite powder in the in-plane orientation is more easily formed in a coated film of a natural graphite powder-dispersed coating liquid.

The resin (binder component) to be used for the dielectric sheet of the present invention is not particularly limited as long as it is a material stable in a solvent to be used for a natural graphite powder-dispersed coating liquid, and various resins can be used. From the aspects of weather resistance and the like, preferred are fluorine resins such as polyvinylidene fluoride (PVDF), copolymer of vinylidene fluoride (VDF) and hexafluoropropylene (HFP) (P(VDF-HFP)) and the like; polyvinyl alcohol (PVA); polyvinyl butyral (PVB); polymethylmethacrylate (PMMA) and the like. Among these, more preferred from the aspects of stability of coating liquid and coating workability are polymethylmethacrylate (PMMA), polyvinylidene fluoride (PVDF) and polyvinyl butyral (PVB), and particularly preferred is polymethylmethacrylate (PMMA).

Examples of the solvent to be used for the natural graphite powder-dispersed coating liquid include organic solvents such as toluene, N-methyl-2-pyrrolidone (NMP), N,N-dimethylformamide, tetrahydrofuran, dimethylacetamide, dimethyl sulfoxide, hexamethylsulforamide, tetramethylurea, acetone, methyl ethyl ketone (MEK), propylene glycol monomethyl ether (PGM) and the like. Any one kind can be used alone, or two or more kinds thereof can be used in mixture.

In a natural graphite powder-dispersed coating liquid, a natural graphite powder having an average particle diameter of 10 µm or less is preferably more uniformly dispersed. Therefore, it is preferable to add a natural graphite powder (10 - 30 wt%, preferably 15 - 20 wt%) and a dispersion stabilizer (0.5 - 1.5 wt%, preferably 1 - 1.2 wt%) to a solvent to prepare a natural graphite powder dispersion liquid wherein the natural graphite powder is dispersed, and add a resin (preferably a resin solution wherein a resin is dissolved in a solvent) to the natural graphite powder dispersion liquid to prepare a natural graphite powder-dispersed coating liquid.

Examples of the dispersing agent include nonionic surfactants such as aromatic ether type, carboxylate ester type, acrylate ester type, phosphate ester type, sulfonate ester type, fatty acid ester type, urethane type, fluorine type, aminoamide type, acrylamide type and the like, cationic surfactants such as phosphonium-containing polymer and the like, anionic surfactants such as carboxylic acid type, phosphoric acid type, sulfonic acid type, hydroxyfatty acid type, fatty acid amide type and the like. Among these, a phosphate ester type-surfactant is preferable from the aspects of dispersing property of the natural graphite powder (particularly, stabilized dispersing property of natural graphite powder in coating liquid with low viscosity) and the like.

A natural graphite powder dispersion liquid is preferably prepared using a disperser (wet grinding mill) and, for example, disper, colloid mill, roller mill, ball mill, sand mill, homogenizer-type disperser, rotational and revolutional type-planetary mixer and the like can be mentioned.

In addition, when a resin (preferably a resin solution wherein a resin is dissolved in a solvent) is mixed with the natural graphite powder dispersion liquid for the preparation of a natural graphite powder-dispersed coating liquid, a resin (preferably a resin solution wherein a resin is dissolved in a solvent) is preferably supplied with stirring in a high-speed stirring mill (disper). In this way, a good dispersion state wherein a natural graphite powder is dispersed in a primary particle state can be maintained.

In the present invention, the natural graphite powder-dispersed coating liquid is preferably prepared to have a content rate of the natural graphite powder to the resin of more than 5% by volume and not more than 20% by volume (preferably 7 - 15% by volume, more preferably 9 - 11% by volume), and the total content of the resin and the natural graphite powder of 10 - 55 wt% (preferably 30 - 50 wt%, more preferably 40 - 50 wt%).
When the content rate of the natural graphite powder to the resin in the coating liquid is not more than 5% by volume, the dielectric property (radio wave absorbing capacity) of the resin sheet obtained by coating and drying tends to decrease. When it exceeds 20% by volume, poor dispersion and precipitation of the natural graphite powder occur, and a resin sheet (dielectric sheet) having uniform properties is difficult to obtain.
When the total content of the resin and the natural graphite powder in the coating liquid exceeds 50 wt%, the coating property of the coating liquid is not stabilized, the concaves and convexes on the surface of the obtained resin sheet (dielectric sheet) grow, and variation (dispersion) of the property as a dielectric tend to occur. In addition, an electromagnetic wave absorber is formed by laminating resin sheets, the thickness accuracy is difficult to achieve. On the other hand, when the total content of the resin and the natural graphite powder in the coating liquid is less than 10 wt%, a coated film having a sufficient thickness is difficult to obtain, and the state of in-plane orientation of natural graphite particles is difficult to achieve.

The dielectric sheet of the present invention is formed by applying a natural graphite powder-dispersed coating liquid onto an exfoliation-processed support (for example, polyethylene terephthalate (PET) film exfoliation-processed with a mold lubricant such as silicone etc. and the like) to form a coated film such that the thickness thereof after drying is 5 - 30 µm, and drying the coated film by heating. While the heating temperature for drying the coated film by heating varies depending on the resin to be used, generally, it is preferably about 80 - 150°C. The heating time is generally about 1 - 5 min.

When applying to an electromagnetic wave absorber, the thus-obtained dielectric sheet is used by peeling off the support from the dielectric sheet.

The volume resistivity (electrical resistivity) of the dielectric sheet of the present invention is preferably 1 × 10⁹ - 1 × 10¹² Ω·cm, more preferably 1 × 10⁹ - 1 × 10¹¹ Ω·cm. When the volume resistivity is within such preferable range, the state of in-plane orientation of in the sheet multiplies in the thickness direction of the sheet to realize a dielectric sheet showing desired preferable dielectric property.

The electromagnetic wave absorber of the present invention can be obtained as follows by using a plurality of dielectric sheets produced as mentioned above;
Using, as a reference, the flow direction of the sheet (Machine Direction, MD), or the direction perpendicular to the flow direction in the plane of the sheet (Transverse Direction, TD),
laminating about 2 - 100 sheets such that Machine Directions of respective sheets (or respective Transverse Directions) form a crossing angle of 90 degrees between two sheets laminated on top of each other, and
heating and pressing the thus-laminated sheets under conditions of temperature 100 - 150°C and pressure 0.1 - 5 MPa.
The thus-laminated sheets are treated by heating and pressing under conditions of temperature 100 - 150°C and pressure 0.1 - 5 MPa.

The Machine Direction (MD) of the sheet means a coating direction of a coating liquid to be applied onto a support during formation of a sheet and the Transverse Direction (TD) means a direction perpendicular to the coating direction of a coating liquid.

The thickness (thickness after heating and press treatments) of the laminated sheet is not particularly limited as long as the radio wave absorption property can be stabilized irrespective of the incident direction of the radio wave. For example, when the absorbing region is 5.8 GHz, the range of 0.8 - 2 mm is preferable, and when the absorbing region is 76 GHz, the range of 0.1 - 0.3 mm is preferable.

### Examples

The present invention is more specifically explained in the following by referring to Examples Comparative Examples.

### (Example 1)

To toluene were added a phosphate ester surfactant and a natural graphite powder (average particle diameter: 5 µm) as dispersants, and the mixture was dispersion processed (bead diameter: 500 µm, circumferential speed of 10 m/sec, processing time: 4 hours) by an Apex mill (ball mill manufactured by Kotobuki Giken Co., LTD.) to prepare a natural graphite powder dispersion liquid (dispersant content: 1 wt%, natural graphite powder content: 30 wt%).
Separately, a resin solution having a PMMA content of 25 wt%, wherein PMMA ("Delpet" manufactured by Asahi Kasei Chemicals Co., Ltd.) was dissolved in toluene, was prepared.
While stirring the natural graphite powder dispersion liquid with a disper (rotation: 200 rpm) for 2 hours, the above-mentioned resin solution was added to the above-mentioned natural graphite powder dispersion liquid and they were mixed to give a natural graphite powder-dispersed coating liquid having a content rate of the natural graphite powder relative to PMMA of 10% by volume, and the total content of PMMA and the natural graphite powder of 50 wt%.
The above-mentioned coating liquid was applied onto a PET film exfoliation-processed with silicone by a comma-direct coating method such that the thickness after drying was 10 µm, and the obtained coated film was dried at 120°C for 1 min. The dried film was peeled from the PET film to give a 10 µm-thick PMMA-natural graphite composite sheet (dielectric sheet).

### (Example 2)

In the same manner as in Example 1 except that the coating thickness of the natural graphite powder-dispersed coating liquid on the PET film was changed such that the thickness after drying was 20 µm a 20 µm-thick PMMA-natural graphite composite sheet was obtained.

### (Example 3)

In the same manner as in Example 1 except that the coating thickness of the natural graphite powder-dispersed coating liquid on the PET film was changed such that the thickness after drying was 30 µm, a 30 µm-thick PMMA-natural graphite composite sheet was obtained.

### (Comparative Example 1)

In the same manner as in Example 1 except that the coating thickness of the natural graphite powder-dispersed coating liquid on the PET film was changed such that the thickness after drying was 70 µm, a 70 µm-thick PMMA-natural graphite composite sheet was obtained.

### (Comparative Example 2)

In the same manner as in Example 1 except that the coating thickness of the natural graphite powder-dispersed coating liquid on the PET film was changed such that the thickness after drying was 35 µm, a 35 µm-thick PMMA-natural graphite composite sheet was obtained.

### (Comparative Example 3)

In the same manner as in Example 1 except that the content rate of the natural graphite powder to PMMA was changed to 5% by volume, a 10 µm-thick PMMA-natural graphite composite sheet was obtained.

### (Comparative Example 4)

The PMMA used in Example was kneaded with a natural graphite powder (15% by volume, average particle diameter: 5 µm) at 200°C for 10 min, and the mixture was press-formed to give a 2000 µm-thick PMMA-natural graphite composite sheet.

The complex dielectric constant and resistivity (Ω·cm) of the PMMA-graphite composite sheets obtained in Examples 1-3 and Comparative Examples 1-4 were measured by the following methods.

### [Measurement of dielectric constant]

Using a network analyzer 8722D (transmitter, detector) manufactured by Agilent Technologies, Inc., a measurement software for material constant 85071 (manufactured by Kanto Denshi Co., Ltd.), and a waveguide of jig for X-band measurement (WSH1-X), the dielectric constant was measured by S-parameter method.
S11 and S21 at 8.2 - 12.4 GHz were measured, the reflection coefficient and permeation coefficient were calculated, and the real part and the imaginary part of the dielectric constant were calculated therefrom.
The samples were rectangle (22.86 mm × 10.16 mm), and were set in sample holder.

### [Measurement of electrical resistivity]

According to a double ring electrode method (ASTM D257), 250 V was applied between the electrodes, and the resistance (volume resistivity) was measured 1 min later.

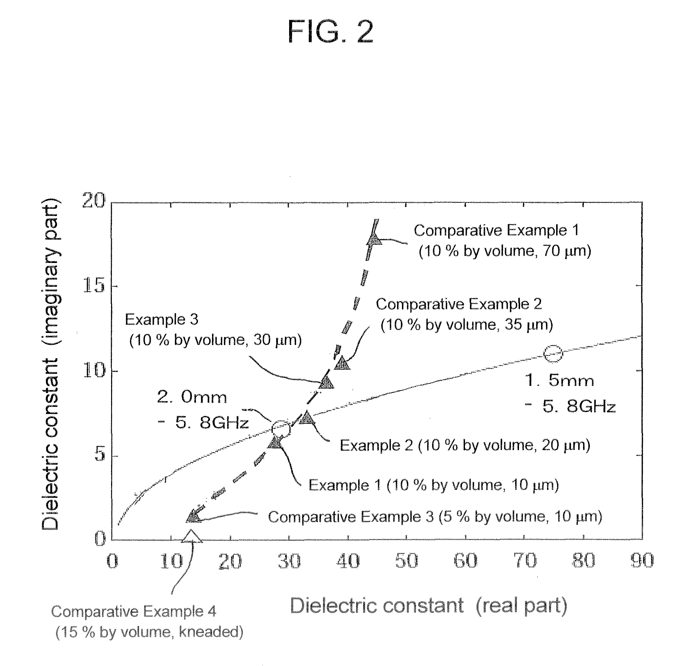

Fig. 2 shows plotting of the real part and imaginary part of the dielectric constants of the PMMA-graphite composite sheets obtained in Examples 1-3 and Comparative Example 1-4, together with the non-reflective curve of 5.8 GHz frequency.
The volume resistivity of the sheets of Examples 1-3 was 4 × 10¹¹ Ω·cm, 2.1 × 10⁹ Ω·cm and 1.0 × 10⁹ Ω·cm, respectively. In addition, the volume resistivity of the sheets of Comparative examples 1 and 4 was 3 × 10⁸ Ω·cm and 2.1 × 10¹⁵ Ω· cm, respectively.

From Fig. 2, it is clear that both the real part and imaginary part of the dielectric constant increase as the thickness increases in the resin-graphite composite sheets obtained by coating and drying a natural graphite powder-dispersed coating liquid having the same graphite content relative to the resin (10% by volume) (Examples 1-3, Comparative Examples 1 and 2). In addition, the dielectric constants (real part, imaginary part) of the 10 to 30 µm-thick sheets of Examples 1-3 are in the vicinity of the non-reflective curve of 5.8 GHz frequency, and have an ideal absorbance capacity relative to the 5.8 GHz frequency.
On the other hand, the dielectric constant (real part, imaginary part) of the 35 µm-thick sheet of Comparative Example 2 is away from the vicinity of the non-reflective curve of 5.8 GHz frequency, the dielectric constant (real part, imaginary part) of the 70 µm-thick sheet of Comparative Example 1 is far away from the non-reflective curve of 5.8 GHz frequency, and they fail to show good absorbance capacity relative to the 5.8 GHz frequency.

In addition, it is clear that the resin-graphite composite sheet of Comparative Example 3, which is obtained by coating and drying a natural graphite powder-dispersed coating liquid (content of graphite to resin 5% by volume, thickness 10 µm), shows a dielectric constant of the imaginary part close to zero, and cannot afford sufficient dielectric property with ease.
Furthermore, it is clear that the resin-graphite composite sheet of Comparative Example 4, which is obtained by forming a kneaded mixture of a natural graphite powder and a resin (content of graphite to rosin 5% by volume, thickness 10 µm), shows a dielectric constant of the imaginary part of zero, and does not express a function as an electromagnetic wave absorber.

### (Examples 4-6, Comparative Examples 5 and 6)

On each of the PMMA-graphite composite sheets (dielectric sheets) obtained in Examples 1-3 and Comparative Examples 1 and 2 were laminated a plurality of sheets such that the machine directions (MD) of respective sheets form a crossing angle of 90 degrees between two sheets to be laminated on top of each other, and the laminated sheets were hot-pressed under the conditions of temperature 120°C, pressure 2 MPa to produce 2 mm-thick laminated sheets (radio wave absorbers).
Example 4: 210 sheets of Example 1 were laminated.
Example 5: 105 sheets of Example 2 were laminated.
Example 6: 70 sheets of Example 3 were laminated.
Comparative Example 5: 30 sheets of Comparative Example 1 were laminated.
Comparative Example 6: 60 sheets of Comparative Example 2 were laminated.

Using the laminated sheets obtained in Examples 4-6 and Comparative Examples 5 and 6, the radio wave absorption in the absorption region of 5.8 GHz was measured. The results are shown in Table 1.
The measurement conditions of the radio wave absorption amount are as described below.

### [Measurement of radio wave absorption]

Using a network analyzer in a 6-side radio wave anechoic room, radio waves within the range of 0 - 18 GHz were irradiated against evaluation samples, and the reflection waves received by an antenna were analyzed by the time domain method.

**Table 1**

| | thickness of dielectric sheet (µm) | number of lamination (sheet) | absorbed amount (dB) |
|---|---|---|---|
| Example 4 | 10 | 210 | 25 |
| Example 5 | 20 | 105 | 25 |
| Example 6 | 30 | 70 | 25 |
| Comparative Example 5 | 35 | 60 | 10 |
| Comparative Example 6 | 70 | 30 | 10 |

From Table 1, it is clear that a laminated sheet obtained by laminating the dielectric sheet of the present invention (laminated sheets of Examples 4-6) can realize an electromagnetic wave absorber showing high radio wave absorption property, even though it is thin.

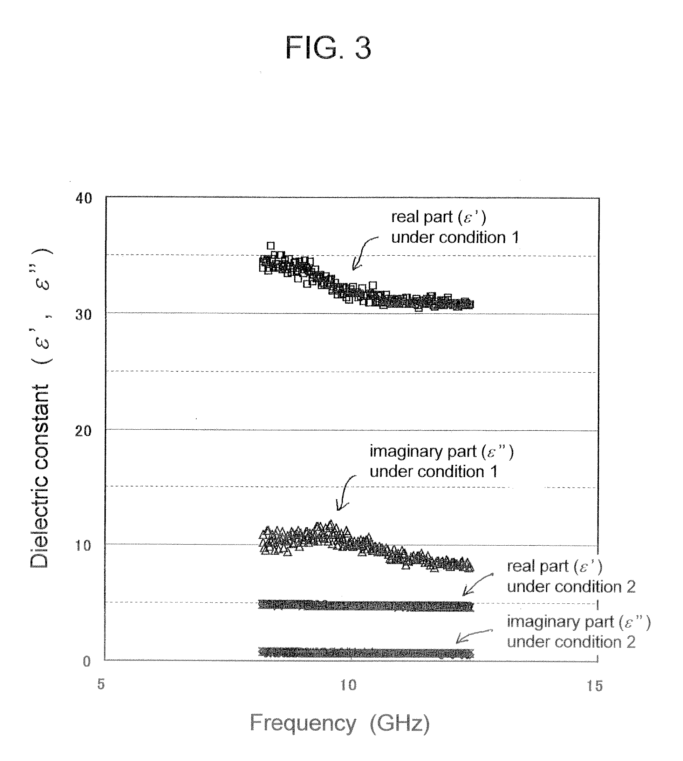

In addition, the dielectric constant of the laminated sheet of Example 2 was measured by a method similar to the above-mentioned method.
The dielectric constant was measured under two conditions of:
condition 1: an electromagnetic wave was irradiated toward the main surface of the laminated sheet from a direction perpendicular to the main surface (PMMA-graphite composite sheet of the top layer), and
conditions 2: an electromagnetic wave was irradiated toward the side face of the laminated sheet from a direction perpendicular to the side face.
In each condition, the frequency was changed by 0.02 GHz between 8 GHz and 12 GHz, and the measurement was performed 200 times. The measurement results are plotted in Fig. 3. In the Figure, ε' shows the real part of the dielectric constant, and ε" shows the imaginary part of the dielectric constant.

From Fig. 3, it is clear that an electromagnetic wave absorber sheet, wherein the resin sheets (dielectric sheets) of the present invention are laminated, has dielectric anisotropy showing various values of dielectric constant depending on the incident direction of the electromagnetic wave into the sheet. Therefore, the electromagnetic wave absorber sheet of the present invention shows dielectric anisotropy showing particularly high dielectric constant to the electromagnetic wave that enters from the direction perpendicular to the sheet surface (direction same as thickness direction of the sheet). When the sheet surface faces the arrival direction of the electromagnetic wave, the sheet can show superior radio wave absorbing capacity.

### Industrial Applicability

The dielectric sheet of the present invention can also be used as an IC (integrated circuit) package, a module substrate, formation of a high dielectric constant layer integrated with an electronic component, particularly, an inner layer capacitor layer of a multi-layer type wiring substrate and the like.

This application is based on JP2010-122124 filed in Japan, the contents of which are encompassed in full herein.

## Claims

1. A dielectric sheet **characterized in that** it comprises a sheet having a thickness of 5 - 30 µm which is formed by drying a coated film of a coating liquid comprising a resin and a natural graphite powder having an average particle diameter of 10 µm or less.

2. The dielectric sheet according to claim 1, wherein the coating liquid comprises a resin, a natural graphite powder having an average particle diameter of 10 µm or less, and a solvent,
the content rate of the natural graphite powder to the resin is more than 5% by volume and not more than 20% by volume, and
the total content of the resin and the natural graphite powder is 10 - 55 wt%.

3. A method of manufacturing a dielectric sheet comprising a natural graphite powder dispersed in a resin, comprising
a step of adding 10 - 30 wt% of a natural graphite powder having an average particle diameter of 10 µm or less and 0.5 - 1.5 wt% of a dispersion stabilizer to a solvent to give a natural graphite powder dispersion liquid wherein the natural graphite powder is dispersed, mixing a resin with the natural graphite powder dispersion liquid to prepare a natural graphite powder-dispersed coating liquid wherein the content rate of the natural graphite powder to the resin is more than 5% by volume and not more than 20% by volume, and the total content of the resin and the natural graphite powder is 10 - 55 wt%,
a step of applying the coating liquid to a support processed for exfoliation, and drying the liquid to form a coated film having a thickness of 5 - 30 µm, and
a step of drying by heating the coated film to produce a sheet having a thickness of 5 - 30 µm, wherein the natural graphite powder having an average particle diameter of 10 µm or less is dispersed in the resin.

4. An electromagnetic wave absorber, wherein a plurality of dielectric sheets according to claim 1 or 2 are laminated.

5. The electromagnetic wave absorber according to claim 4, wherein the plurality of dielectric sheets are laminated such that the dielectric sheets laminated to abut each other are in the relationship of their machine directions forming a crossing angle of 90 degrees with each other.
